# EUROPÄISCHE PATENTSCHRIFT

(11) **EP 3 665 122 B1**
(45) Veröffentlichungstag und Bekanntmachung des Hinweises auf die Patenterteilung: **24.05.2023**
(21) Anmeldenummer: 18750130.9
(22) Anmeldetag: 30.07.2018
(51) Int. Cl.: B81B 7/00

(54) **MIKROMECHANISCHE VORRICHTUNG UND ENTSPRECHENDES HERSTELLUNGSVERFAHREN**
MICROMECHANICAL DEVICE AND CORRESPONDING PRODUCTION METHOD
DISPOSITIF MICROMÉCANIQUE ET PROCÉDÉ DE FABRICATION CORRESPONDANT

(30) Priorität: 07.08.2017 DE 102017213631
(43) Veröffentlichungstag der Anmeldung: 17.06.2020
(73) Patentinhaber: Robert Bosch GmbH, 70442 Stuttgart (DE)
(72) Erfinder: STRAUB, Rainer, 72119 Ammerbuch (DE); STEIGERT, Tina, 70176 Stuttgart (DE); PINTER, Stefan, 72764 Reutlingen (DE); BAADER, Johannes, 79104 Freiburg (DE); SCHORR, Nicolas, 72762 Reutlingen (DE)
(86) Internationale Anmeldenummer: PCT/EP2018/070579
(87) Internationale Veröffentlichungsnummer: WO 2019/030040

(56) Entgegenhaltungen:
- DE-A1-102010 029 760
- US-A1- 2012 322 257
- US-A1- 2015 151 959
- US-B1- 6 406 636
- US-B1- 6 956 283

## Beschreibung

Die vorliegende Erfindung betrifft eine mikromechanische Vorrichtung und ein entsprechendes Herstellungsverfahren.

### Stand der Technik

Obwohl auch beliebige mikromechanische Bauelemente anwendbar sind, werden die vorliegende Erfindung und die ihr zugrundeliegende Problematik anhand von Bauelementen mit Mikrochips erläutert.

An Mikrochips werden hohe Anforderungen bezüglich der Dichtheit gestellt. Zum Beispiel müssen diese sogenannten Feuchte-Erprobungen standhalten, ohne dass es zu Korrosion, etwa durch eine Redox-Reaktion, wie zum Beispiel Intermetall-Korrosion eines an der Sägefacette der Chips exponierten Aluminium-Silber-Metallstapels, kommt. Der Metallstapel ist durchgängig, also vollflächig über die gesamte Chipoberfläche abgeschieden und ist somit auch der Untergrund einer Sealglasverbindung, welche etwa aus der DE 10 2005 040 789 A1 bekannt ist. Korrodiert dieser Metallstapel unter Einwirkung von Feuchte wird der Sealglasverbindung der Haftgrund entzogen und eine ausreichende Dichtheit kann möglicherweise beeinträchtigt sein. Eine Gegenmaßnahme nach dem Stand der Technik wäre das lokale Entfernen des Metalls im Chipaußenbereich, wie etwa in der DE 103 42 155 A1 beschrieben.

Das Dokument US 2015 / 0151959 beschreibt eine mikromechanische Vorrichtung gemäß dem Obergriff des Anspruchs 1.

### Offenbarung der Erfindung

Die vorliegende Erfindung offenbart eine mikromechanische Vorrichtung nach Anspruch 1 und ein entsprechendes Herstellungsverfahren nach Anspruch 7.

Die mikromechanische Vorrichtung umfasst ein Kappensubstrat, wobei in der Vorderseite des Basissubstrats mindestens ein umlaufender Trenchgraben mit unebenen Seitenwänden ausgebildet ist; wobei die Vorderseite des Basissubstrats und der Trenchgraben mit mindestens einer Metallschicht beschichtet sind; wobei die unebenen Seitenwände des Trenchgrabens nicht konform von dem Metall bedeckt sind, so dass sie keinen elektrischen Strompfad in einer senkrecht zur Vorderseite verlaufenden Richtung bilden; und wobei im Bereich des Trenchgrabens auf der Vorderseite des Basissubstrats ein Sealglas-Verschluss zwischen dem Basissubstrat und dem Kappensubstrat ausgebildet ist. Hierbei überdeckt der Sealglas-Verschluss den Trenchgraben vollständig. Bevorzugte Weiterbildungen sind Gegenstand der jeweiligen Unteransprüche.

### Vorteile der Erfindung

Die Erfindung schafft die Möglichkeit, eine mikromechanische Vorrichtung mit verringerter Empfindlichkeit herzustellen, bei der der metallische Korrosionspfad (Strompfad) zwischen Umgebung und gekapseltem Inneren mittels einer Trenchgrabenstruktur unterbrochen ist, so dass die Umgebung und das gekapselte Innere galvanisch getrennt wird, ohne dass die Metallschicht gesondert strukturiert werden muss. Die Metallschicht bleibt somit im Inneren intakt und ist an den unebenen Seitenwänden des Trenchgrabens unterbrochen. Dadurch lässt sich die Robustheit gegenüber Feuchtigkeit und verschiedenen Umwelteinflüssen der mikromechanischen Vorrichtung besonders vorteilhaft erhöhen.

Gemäß einer bevorzugten Weiterbildung der erfindungsgemäßen mikromechanische Vorrichtung weist die Metallschicht mindestens ein Metall aus der Gruppe bestehend aus Aluminium, Silber und Gold, auf. Mit diesen Metallen lassen sich viele der funktionalen Aufgabenstellungen an mikromechanische Vorrichtungen besonders vorteilhaft lösen.

Gemäß einer bevorzugten Weiterbildung der erfindungsgemäßen mikromechanische Vorrichtung sind die Vorderseite des Basissubstrats und der Trenchgraben mit zwei unterschiedlichen Metallschichten beschichtet. Hierdurch ergeben sich eine Vielzahl zusätzlicher Anwendungen und gleichzeitig wird eine Intermetallkorrosion vermieden, wie sie in Anwendungen auftreten kann, bei der Metalle mit stark unterschiedlichen elektrochemischen Potentialen wie Silber/Aluminium verwendet werden.

Gemäß einer bevorzugten Weiterbildung der erfindungsgemäßen mikromechanische Vorrichtung sind das Basissubstrat und der Trenchgraben mit einer Metallschicht aus Silber beschichtet, auf der eine Metallschicht aus Aluminium aufgebracht ist. Dadurch lassen sich viele der Aufgabenstellungen an mikromechanische Vorrichtungen mit einem Mikrochip besonders vorteilhaft lösen, während eine Intermetallkorrosion vermieden werden kann.

Gemäß einer bevorzugten Weiterbildung der erfindungsgemäßen mikromechanischen Vorrichtung hat der Trenchgraben eine Breite von 10 Mikrometer bis 100 Mikrometer und eine Tiefe von 20 Mikrometer bis 200 Mikrometer. Durch die Wahl dieser Abmessungen kann der Strompfad zwischen beiden Seiten des Trenchgrabens effektiv unterbrochen werden.

Gemäß einer bevorzugten Weiterbildung der erfindungsgemäßen mikromechanischen Vorrichtung weisen die unebenen Seitenwände des Trenchgrabens eine Mehrzahl von Einschnitten, vorzugsweise mit einer Tiefe von 1 Mikrometer bis 10 Mikrometer, auf. Hierdurch kann der Strompfad zwischen beiden Seiten des Trenchgrabens besonders zuverlässig unterbrochen werden.

Gemäß der erfindungsgemäßen mikromechanischen Vorrichtung überdeckt der Sealglas-Verschluss den Trenchgraben vollständig.

### Kurze Beschreibung der Zeichnungen

Die vorliegende Erfindung wird nachfolgend anhand der in den schematischen Figuren der Zeichnungen angegebenen Ausführungsbeispiele näher erläutert. Dabei zeigen:
- FIG. 1:: eine schematische Darstellung zur Erläuterung einer mikromechanischen Vorrichtung gemäß einer ersten Ausführungsform der vorliegenden Erfindung im Querschnitt;
- FIG. 2:: eine schematische Darstellung zur Erläuterung einer mikromechanischen Vorrichtung gemäß der ersten Ausführungsform der vorliegendend Erfindung in der Draufsicht, gezeigt ohne Kappensubstrat; und
- FIG. 3:: ein schematisches Flussdiagramm zum Erläutern eines Verfahrens zum Herstellen mikromechanischen Vorrichtung gemäß einer zweiten Ausführungsform.

### Ausführungsformen der Erfindung

In den Figuren bezeichnen gleiche Bezugszeichen gleiche bzw. funktionsgleiche Elemente.

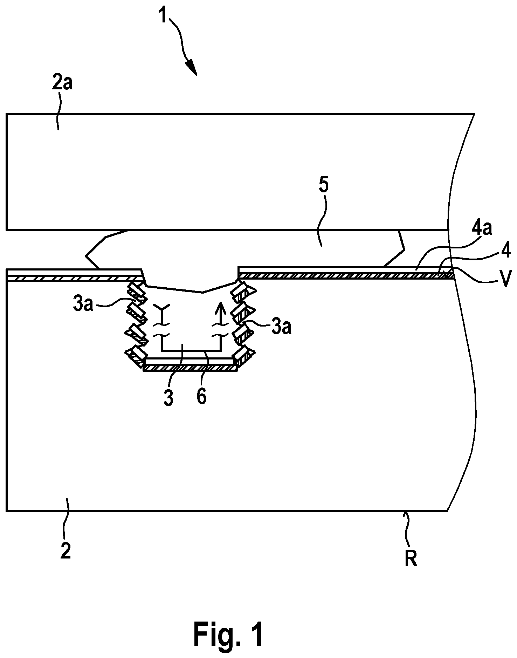

FIG. 1 ist eine schematische Darstellung zur Erläuterung einer mikromechanischen Vorrichtung gemäß einer ersten Ausführungsform der vorliegenden Erfindung im Querschnitt.

In FIG. 1 bezeichnet Bezugszeichen 1 die mikromechanische Vorrichtung, die ein Basissubstrat 2 mit einer Vorderseite V und einer Rückseite R aufweist. Bezugszeichen 2a bezeichnet ein Kappensubstrat, 3 einen umlaufenden Trenchgraben, 3a unebene Seitenwände des Trenchgrabens 3, 4 eine erste Metallschicht und 4a eine zweite Metallschicht, 5 einen Sealglas-Verschluss und 6 einen unterbrochenen Strompfad an den unebenen Seitenwänden 3a aufgrund einer nicht konformen Ausbildung der Metallschichten 4, 4a.

Ein bekanntes Verfahren zur galvanischen Trennung einer Metallschicht und/oder mehrerer Metallschichten ist das selektive Entfernen des Metalls in gewissen Bereichen, das heißt Strukturierung des Metalls, z.B. mittels Lithographie und nachfolgendem Ätzen.

Kern dieser Ausführungsform ist die Vermeidung eines solchen Lithographie- und Ätzschrittes, indem bereits vor dem Aufbringen der ersten Metallschicht 4 und der zusätzlichen Metallschicht 4a auf der Vorderseite V des Basissubstrats 2 der umlaufende Trenchgraben 3 mit unebenen Seitenwänden 3a ausgebildet wird, wobei die unebenen Seitenwände 3a während der anschließenden Abscheidung der ersten Metallschicht 4 und der zusätzlichen Metallschicht 4a nicht konform bedeckt werden. Zum Beispiel wird ein 35 Mikrometer breiter und 90 Mikrometer tiefer Trenchgraben 3 umlaufend im Bereich der Vorderseite V des Basissubstrats 2 in Silizium mittels sogenanntem Trenchen oder DRIE geätzt.

Die Seitenwände 3a dieses Trenchgrabens 3 weisen die für diesen Trench-Prozess typischen Einschnitte auf. In diesen lokalen Einschnitten wird das über einen Sputterprozess aufgebrachte erste Metall 4 und zweite Metall 4a nicht konform abgeschieden, also nur auf der Unterseite der Einschnitte. Auf diese Weise ist der Strompfad 6 zwischen der Umgebung und dem gekapselten Innneren unterbrochen und eine etwa Intermetallkorrosion verursachende Redox-Reaktion kann somit im Inneren nicht ablaufen.

Vorteile dieser Vorstrukturierung des Basissubstrats 2 sind der Entfall der für die Herstellung einer Lackmaske benötigten Arbeitsgänge wie Belacken, Belichten, Entwickeln, Inprozesskontrolle, Ausheizen und das Entfallen der Notwendigkeit eines Metallätzens, was Prozesskosten spart, sowie der Entfall der für das Entfernen der Lackmaske benötigten Arbeitsgänge wie Veraschen im Sauerstoffplasma, spezielle Nassreinigungen, Inprozesskontrolle oder Ausheizen. Der Wegfall oben genannter Prozessschritte hat eine reduzierte Beanspruchungen der Metallschicht zur Folge. Dadurch können Verunreinigungen, erhöhte Rauigkeit der Oberfläche, lokale Anätzungen, Kontamination, veränderte optische Eigenschaften, Temperaturbelastung, Kratzer, veränderte chemische Eigenschaften durch z.B. Angriff von Sauerstoffradikalen beim Veraschen der Lackmaske verhindert werden. Und in manchen Prozesszuständen des Basissubstrats 2 ist keine Lithographie möglich und somit entfällt diese Notwendigkeit der Metallstrukturierung komplett.

Ein mittels reaktiven lonentiefenätzens, DRIE oder Trenching-Prozess hergestellter Trenchgraben 3 weist an seinen Seitenwänden 3a die lokalen Einschnitte im Mikromaßstab auf, welche bei der Abscheidung von unterschiedlichen Metallen 4 und 4a mittels Kathoden-Zerstäubens oder Sputtern nicht belegt werden. Dadurch wird der Strompfad zwischen beiden Seiten des Trenchgrabens 3 unterbrochen bzw. hochohmig. Entsprechende Widerstandsmessungen zeigen einen elektrischen Widerstand von etwa 600 Kiloohm der Trenchgrabenstruktur gegenüber 2 Ohm ohne Trenchgraben 3.

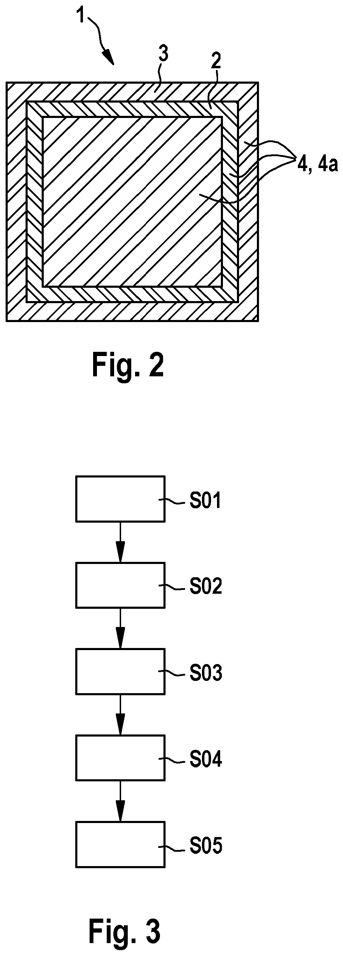

FIG. 2 ist eine schematische Darstellung zur Erläuterung einer mikromechanischen Vorrichtung gemäß der ersten Ausführungsform der vorliegenden Erfindung in der Draufsicht, gezeigt ohne Kappensubstrat.

Die oben beschriebene Funktion des Trenchgrabens 3 macht sich die vorliegende Erfindung zu Nutze, um den Strompfad zwischen der den Umwelteinflüssen ausgesetzten Umgebung und dem hermetisch dicht gepackten Inneren aufzutrennen. Ein Kontakt des Basissubstrats 2 mit elektrolythaltigem Medium, wie beispielsweise einer NaCl-Lösung, kann zum Beispiel Intermetall-Korrosion verursachen, wenn ein erstes Metall als erste Metallschicht 4 und ein zweites Metall als zweite Metallschicht 4a wie bei einem Silber-Aluminium-Stapel abgeschieden wurde. So kann im Inneren eine Intermetall-Korrosion nicht mehr stattfinden, da der dafür benötigte Elektronentransfer unterbrochen ist. Im elektrochemischen Sinn handelt es sich bei Korrosion vor allem um Redoxreaktionen von Metallen unter dem Einfluss von Wasser, Salzlösungen und Säuren, sowie zwischen unterschiedlichen Metallen.

Zur Herstellung einer hermetischen Abdichtung des Inneren gegenüber der Umgebung wird der Sealglas-Verschluss 5 verwendet, welcher durch Kohäsionskräfte während des Fügeprozesses in den Trenchgraben 3 gezogen wird und dabei einen feuchtedichten Abschluss ausbildet.

FIG. 3 ist ein schematisches Flussdiagramm zum Erläutern eines Verfahrens zum Herstellen mikromechanischen Vorrichtung mit einem Mikrochip mit verringerter Empfindlichkeit gegen Metallkorrosion gemäß einer zweiten Ausführungsform.

In einem Schritt S01 wird ein Basissubstrat 2 bereitgestellt. In diesem Basissubstrat 2 wird in einem Schritt S02 mindestens ein umflaufender Trenchgraben 3 mit unebenen Seitenwänden 3a ausgebildet und in einem Schritt S03 werden das Basissubstrat 2 und der Trenchgraben 3 mit einer ersten Metallschicht 4 z.B. aus Silber beschichtet. In einem Schritt S04 kann noch mit mindestens einer weiteren Metallschicht 4a, welches ein Metall (z.B. Aluminium) aufweist, das sich vom Metall der ersten Metall 4 unterscheidet, beschichtet werden und in einem Schritt S05 wird dann im Bereich des Trenchgrabens 3 der Sealglass-Verschluss 5 in ansich bekannter Weise ausgebildet.

Obwohl die vorliegende Erfindung anhand bevorzugter Ausführungsbeispiele beschrieben wurde, ist sie darauf nicht beschränkt. Insbesondere sind die genannten Materialien und Topologien nur beispielhaft und nicht auf die erläuterten Beispiele beschränkt.

Besonders bevorzugte weitere Anwendungen für die erfindungsgemäße mikromechanische Vorrichtung sind beispielsweise bei Anwendungen mit erhöhten Umwelteinflüssen oder chemisch reaktiven Atmosphären.

## Patentansprüche

1. Mikromechanische Vorrichtung (1), umfassend
ein Basissubstrat (2) mit einer Vorderseite (V) und einer Rückseite (R);
ein Kappensubstrat (2a),
wobei in der Vorderseite (V) des Basissubstrats (2) mindestens ein umlaufender Trenchgraben (3) ausgebildet ist,
wobei im Bereich des Trenchgrabens (3) auf der Vorderseite (V) des Basissubstrats (2) ein Sealglas-Verschluss (5) zwischen dem Basissubstrat (2) und dem Kappensubstrat (2a) ausgebildet ist,
wobei der Sealglas-Verschluss (5) den Trenchgraben (3a) vollständig überdeckt,
**dadurch gekennzeichnet, dass**
der umlaufende Trenchgraben mit unebenen Seitenwänden (3a) ausgebildet ist,
die Vorderseite (V) des Basissubstrats (2) und der Trenchgraben (3) mit mindestens einer Metallschicht (4, 4a) beschichtet sind,
wobei die unebenen Seitenwände (3a) des Trenchgrabens (3) nicht konform von dem Metall (4, 4a) bedeckt sind, so dass sie keinen elektrischen Strompfad in einer senkrecht zur Vorderseite (V) verlaufenden Richtung bilden.

2. Mikromechanische Vorrichtung (1) nach Anspruch 1, wobei die Metallschicht (4, 4a) mindestens ein Metall aus der Gruppe bestehend aus Aluminium, Silber und Gold aufweist.

3. Mikromechanische Vorrichtung (1) nach Anspruch 1 oder 2, wobei die Vorderseite des Basissubstrats (2) und der Trenchgraben (3) mit zwei unterschiedlichen Metallschichten (4, 4a) beschichtet sind.

4. Mikromechanische Vorrichtung (1) nach Anspruch 3, wobei die Vorderseite des Basissubstrats (2) und der Trenchgraben (3) mit einer Metallschicht (4) aus Silber beschichtet sind, auf der eine Metallschicht (4a) aus Aluminium aufgebracht ist.

5. Mikromechanische Vorrichtung (1) nach einem der vorangegangenen Ansprüche, wobei der Trenchgraben (3) eine Breite von 10 Mikrometer bis 100 Mikrometer und eine Tiefe von 20 Mikrometer bis 200 Mikrometer hat.

6. Mikromechanische Vorrichtung (1) nach einem der vorangegangenen Ansprüche, wobei die unebenen Seitenwände (3a) des Trenchgrabens (3) eine Mehrzahl von Einschnitten (3a), vorzugsweise mit einer Tiefe von 1 Mikrometer bis 10 Mikrometer, aufweisen.

7. Verfahren zum Herstellen einer mikromechanischen Vorrichtung (1) mit den Schritten:
Bereitstellen von einem Basissubstrat (2) mit einer Vorderseite (V) und einer Rückseite (R);
Bereitstellen von einem Kappensubstrat (2a),
wobei in der Vorderseite (V) des Basissubstrats (2) mindestens ein umlaufender Trenchgraben (3) mit unebenen Seitenwänden (3a) ausgebildet wird;
die Vorderseite (V) des Basissubstrats (2) und der Trenchgraben (3) mit mindestens einer Metallschicht (4, 4a) beschichtet wird,
wobei die unebenen Seitenwände (3a) des Trenchgrabens (3) nicht konform von dem Metall (4, 4a) bedeckt werden, so dass sie keinen elektrischen Strompfad in einer senkrecht zur Vorderseite (V) verlaufenden Richtung bilden; und
wobei im Bereich des Trenchgrabens (3) auf der Vorderseite (V) des Basissubstrats (2) ein Sealglas-Verschluss (5) zwischen dem Basissubstrat (2)
und dem Kappensubstrat (2a) ausgebildet wird, und der Sealglas-Verschluss (5) den Trenchgraben (3a) vollständig überdeckt.

## Claims

1. Micromechanical device (1), comprising
a base substrate (2) with a front side (V) and a rear side (R);
a cap substrate (2a),
wherein at least one encircling trench (3) is formed in the front side (V) of the base substrate (2),
wherein, in the region of the trench (3) on the front side (V) of the base substrate (2), a seal glass closure (5) is formed between the base substrate (2) and the cap substrate (2a),
wherein the seal glass closure (5) completely covers the trench (3a),
**characterized in that**
the encircling trench is formed with uneven side walls (3a),
the front side (V) of the base substrate (2) and the trench (3) are coated with at least one metal layer (4, 4a),
wherein the uneven side walls (3a) of the trench (3) are covered in a non-conformal manner by the metal (4, 4a), such that they do not form an electrical current path in a direction running perpendicularly with respect to the front side (V).

2. Micromechanical device (1) according to Claim 1, wherein the metal layer (4, 4a) comprises at least one metal from the group consisting of aluminium, silver and gold.

3. Micromechanical device (1) according to Claim 1 or 2, wherein the front side of the base substrate (2) and the trench (3) are coated with two different metal layers (4, 4a) .

4. Micromechanical device (1) according to Claim 3, wherein the front side of the base substrate (2) and the trench (3) are coated with a metal layer (4) composed of silver, to which a metal layer (4a) composed of aluminium is applied.

5. Micromechanical device (1) according to one of the preceding claims, wherein the trench (3) has a width of 10 micrometres to 100 micrometres and a depth of 20 micrometres to 200 micrometres.

6. Micromechanical device (1) according to one of the preceding claims, wherein the uneven side walls (3a) of the trench (3) have a plurality of indentations (3a), preferably with a depth of 1 micrometre to 10 micrometres.

7. Method for producing a micromechanical device (1), comprising the steps:
providing a base substrate (2) with a front side (V) and a rear side (R);
providing a cap substrate (2a),
wherein at least one encircling trench (3) with uneven side walls (3a) is formed in the front side (V) of the base substrate (2);
the front side (V) of the base substrate (2) and the trench (3) are coated with at least one metal layer (4, 4a),
wherein the uneven side walls (3a) of the trench (3) are covered in a non-conformal manner by the metal (4, 4a), such that they do not form an electrical current path in a direction running perpendicularly with respect to the front side (V); and
wherein, in the region of the trench (3) on the front side (V) of the base substrate (2), a seal glass closure (5) is formed between the base substrate (2) and the cap substrate (2a), and the seal glass closure (5) completely covers the trench (3a).

## Revendications

1. Dispositif micromécanique (1), comprenant
un substrat de base (2) pourvu d'une face avant (V) et d'une face arrière (R) ;
un substrat de couverture (2a),
dans lequel au moins une tranchée périphérique (3) est réalisée dans la face avant (V) du substrat de base (2),
dans lequel, dans la zone de la tranchée (3), sur la face avant (V) du substrat de base (2), une fermeture en verre de scellement (5) est réalisée entre le substrat de base (2) et le substrat de couverture (2a),
dans lequel la fermeture en verre de scellement (5) recouvre complètement la tranchée (3a),
**caractérisé en ce que**
la tranchée périphérique est réalisée avec des parois latérales inégales (3a),
la face avant (V) du substrat de base (2) et la tranchée (3) sont recouvertes d'au moins une couche métallique (4, 4a),
dans lequel les parois latérales inégales (3a) de la tranchée (3) ne sont pas recouvertes de manière conforme par le métal (4, 4a) de sorte qu'elles ne forment aucun trajet de courant électrique dans une direction s'étendant perpendiculairement à la face avant (V).

2. Dispositif micromécanique (1) selon la revendication 1, dans lequel la couche métallique (4, 4a) présente au moins un métal du groupe composé d'aluminium, d'argent et d'or.

3. Dispositif micromécanique (1) selon la revendication 1 ou 2, dans lequel la face avant du substrat de base (2) et la tranchée (3) sont recouvertes de deux couches métalliques différentes (4, 4a) .

4. Dispositif micromécanique (1) selon la revendication 3, dans lequel la face avant du substrat de base (2) et la tranchée (3) sont recouvertes d'une couche métallique (4) en argent à laquelle est appliquée une couche métallique (4a) en aluminium.

5. Dispositif micromécanique (1) selon l'une quelconque des revendications précédentes, dans lequel la tranchée (3) présente une largeur de 10 micromètres à 100 micromètres et une profondeur de 20 micromètres à 200 micromètres.

6. Dispositif micromécanique (1) selon l'une quelconque des revendications précédentes, dans lequel les parois latérales inégales (3a) de la tranchée (3) présentent une pluralité d'incisions (3a), de préférence d'une profondeur de 1 micromètre à 10 micromètres.

7. Procédé de fabrication d'un dispositif micromécanique (1), comprenant les étapes consistant à :
fournir un substrat de base (2) pourvu d'une face avant (V) et d'une face arrière (R) ;
fournir un substrat de couverture (2a),
dans lequel au moins une tranchée périphérique (3) pourvue de parois latérales inégales (3a) est réalisée dans la face avant (V) du substrat de base (2) ;
la face avant (V) du substrat de base (2) et la tranchée (3) sont recouvertes d'au moins une couche métallique (4, 4a),
dans lequel les parois latérales inégales (3a) de la tranchée (3) ne sont par recouvertes de manière conforme par le métal (4, 4a) de sorte qu'elles ne forment aucun chemin de courant électrique dans une direction d'étendant perpendiculairement à la face avant (V) ; et
dans lequel, dans la zone de la tranchée (3) sur la face avant (V) du substrat de base (2), une fermeture en verre de scellement (5) est réalisée entre le substrat de base (2) et le substrat de couverture (2a), et la fermeture en verre de scellement (5) couvre entièrement la tranchée (3a).
